(19) Europäisches Patentamt / European Patent Office / Office européen des brevets

(11) **EP 1 862 849 A1**

(12) **DEMANDE DE BREVET EUROPEEN**

(43) Date de publication:
**05.12.2007 Bulletin 2007/49**

(51) Int Cl.:
*G02F 1/15* (2006.01)     *C23C 14/34* (2006.01)

(21) Numéro de dépôt: **07301062.1**

(22) Date de dépôt: **24.05.2007**

(84) Etats contractants désignés:
**AT BE BG CH CY CZ DE DK EE ES FI FR GB GR HU IE IS IT LI LT LU LV MC MT NL PL PT RO SE SI SK TR**
Etats d'extension désignés:
**AL BA HR MK YU**

(30) Priorité: **30.05.2006 FR 0604827**

(71) Demandeur: **Schefenacker Vision Systems France**
**77191 Dammarie-Les-Lys Cedex (FR)**

(72) Inventeurs:
• **Duroux, Bernard**
  **78890 Garancieres (FR)**
• **Billard, Alain**
  **54000 Nancy (FR)**
• **Horwat, David**
  **54000 Nancy (FR)**

(74) Mandataire: **Kedinger, Jean-Paul**
**Cabinet Malemont**
**42, avenue du Président Wilson**
**75116 Paris (FR)**

(54) **Cellule électrochrome, son utilisation dans la réalisation d'une vitre ou d'un rétroviseur et son procédé de réalisation**

(57)     L'invention a pour objet une cellule électrochrome comprenant une couche (4) de matière électrochrome et, appliquée sur celle-ci une couche (3) d'électrolyte, des moyens (7,8,9) étant prévus pour établir une différence de potentiel entre ces couches ; l'électrolyte comprend au moins un composé de formule générale

$$Na_{1+x} Zr_2 Six P_{3-x} O_{12} \qquad (1)$$

dans laquelle x est choisi pour répondre aux conditions suivantes : $1,6 \leq x \leq 2,4$.
    L'invention a également pour objet une vitre ou un rétroviseur comportant une telle cellule.

FIG.1

EP 1 862 849 A1

**Description**

La présente invention a pour objet une cellule électrochrome comportant un empilement de couches comprenant une couche de matière électrochrome inorganique et transparente et, appliquée sur celle-ci, une couche d'un électrolyte inorganique et transparent, des moyens étant prévus pour établir une différence de potentiel entre ces couches et la matière électrochrome et l'électrolyte étant choisis pour que sous l'effet de cette différence de potentiel des cations migrent, de manière réversible, depuis l'électrolyte vers la matière électrochrome pour venir s'insérer dans cette dernière en provoquant une modification de son pouvoir d'absorption de la lumière.

Elle a également pour objet des applications de cette cellule et un procédé de réalisation de cette dernière.

Dans les cellules électrochromes connues du type ci-dessus, utilisation est généralement faite, en tant que matières électrochromes, de composés de métaux de transition, en particulier, l'oxyde de tungstène ($WO_3$) et l'oxyde de vanadium ($V_2O_5$).

Ces deux dernières matières sont en effet susceptibles d'intégrer, par insertion, des cations tels que des protons ($H^+$), $Li^+$, $Na^+$ et $K^+$ par exemple.

Cette insertion s'accompagne d'une modification chimique desdites matières, à l'origine d'un changement de couleur, c'est-à-dire d'une augmentation du pouvoir d'absorption de la lumière.

Ainsi, par exemple, $WO_3$ est incolore à l'état normal et est, par suite de l'insertion de cations, transformé en un complexe coloré de couleur bleu.

On ajoutera que ladite insertion de cations est obtenue en choisissant l'électrolyte susmentionné afin que celui-ci, sous l'effet d'une différence de potentiel entre cet électrolyte et la matière électrochrome, libère des cations qui viennent s'insérer dans la matière électrochrome.

On précisera que ce phénomène d'insertion est réversible, en ce sens qu'en appliquant une différence de potentiel inverse de celle provoquant l'insertion des cations, il y a migration de ces mêmes cations en retour vers l'électrolyte, ce qui s'accompagne de la transformation du complexe coloré susmentionné en $WO_3$ incolore.

Dans les cellules connues du type ci-dessus, l'électrolyte est constitué par un conducteur ionique solide, organique ou inorganique.

Or, les empilements comprenant un conducteur ionique organique, tel qu'un polymère, sont difficiles à réaliser avec une grande précision et uniformité d'épaisseur en raison du caractère liquide ou pâteux de ce type de conducteur, caractère qui lui est conféré par la présence de solvants ; ce manque de précision et d'uniformité est à l'origine de la formation de marbrures lors de la polarisation de l'empilement.

En outre, l'étape de réalisation de la couche de conducteur ionique organique (injection du conducteur dans l'espace formé entre deux couches de verre à écartement constant, puis scellement de cet espace) est non seulement difficile à mettre en oeuvre, mais encore elle ne s'intègre pas dans le procédé de réalisation des autres couches de l'empilement, procédé qui est du type dépôt physique en phase vapeur ; il s'ensuit que deux techniques différentes de fabrication sont indispensables pour réaliser l'empilement, ce qui complique la fabrication de ce dernier.

Par ailleurs, dans le cas de conducteurs ioniques inorganiques tels que $Ta_2O_5$: H hydraté, la conduction ionique varie de façon extrêmement rapide avec le degré d'hydratation ; il est dès lors indispensable de veiller à ce que les conditions de préparation d'un tel conducteur hydraté permettent d'obtenir de manière précise et fiable le degré d'hydratation souhaité, ce qui est extrêmement difficile à l'échelle industrielle.

Le but de la présente invention est de remédier aux inconvénients énumérés ci-dessus et à cet effet il est proposé une cellule électrochrome conforme au premier paragraphe de cette description, cette cellule étant caractérisée en ce que lesdits cations sont des cations $Na^+$ et l'électrolyte comprend au moins un composé de formule générale :

$$Na_{1+x} \, Zr_2 \, Si_x \, P_{3-x} \, O_{12} \qquad (1)$$

dans laquelle x est choisi pour répondre aux conditions suivantes : $1,6 \leq x \leq 2,4$, x étant de préférence sensiblement égal à 2.

L'électrolyte de formule (1) ci-dessus correspond à la série des NASICON (forme cristallisée) ou des NASIGLAS (forme amorphe), qui sont des céramiques conductrices ioniques, le passage de la forme amorphe à la forme cristallisée étant obtenu par traitement thermique.

Par rapport aux électrolytes de l'état antérieur de la technique, le composé de formule (1) présente de multiples avantages.

Ainsi, il est stable chimiquement, possède de bonnes propriétés mécaniques et de conductivité (se laisse aisément traverser par les ions $Na^+$) et est opérationnel à température ambiante.

Il est caractérisable de sorte qu'il est possible de doser tous les éléments qui le constituent ; sa conductivité n'est pas sensiblement influencée par son degré d'humidité.

Enfin, comme on le verra ci-après, son procédé de préparation s'harmonise parfaitement avec le procédé de préparation des autres couches de l'empilement.

La matière électrochrome de la cellule selon l'invention est avantageusement constituée de l'oxyde de tungstène ($WO_3$) ou de l'oxyde de vanadium ($V_2O_5$) , préférence étant donnée à $WO_3$.

Dans ce cas, la modification du pouvoir d'absorption de la lumière de la matière électrochrome correspond à un changement de couleur ; $WO_3$ et $V_2O_5$ incolores à leur état normal se transforment sous l'effet de l'insertion en leur sein de cations $Na^+$ provenant du composé de formule (1), respectivement en un complexe coloré bleu et un complexe coloré brun.

L'application d'une différence de potentiel inverse produit l'effet inverse, c'est-à-dire une migration en retour des cations $Na^+$ vers le composé (1), laquelle migration s'accompagne d'une transformation desdits complexes colorés respectivement en $WO_3$ et $V_2O_5$ incolores.

Selon un mode de réalisation, la cellule comprend en outre une couche de matière transparente constituant une réserve de cations $Na^+$, disposée sur la face externe de la couche d'électrolyte, et dotée de propriétés de conduction ionique.

Cette réserve permet de pallier une insuffisance éventuelle de cations $Na^+$ provenant de l'électrolyte.

Cette même réserve peut par exemple comprendre de l'oxyde de titane ($TiO_2$) poreux ou non poreux et dopé en Na ou une alumine β [de formule $(Na_2O)_x (Al_{22}O_{33})_{1-x}$ avec $0,15 < x < 0, 3$].

De tels composés présentent l'avantage d'être non seulement des conducteurs ioniques, mais également des conducteurs électroniques.

De ce fait, ils constituent une transition entre l'électrolyte purement conducteur ionique et les moyens purement conducteurs électroniques d'établissement d'une différence de potentiel normalement destinés à être appliqués directement sur l'électrolyte ; cette transition assure un bien meilleur fonctionnement de la cellule et évite l'obligation de mettre en oeuvre une différence de potentiel trop élevée.

Les moyens susmentionnés pour établir une différence de potentiel comprennent une première électrode transparente disposée sur la face externe de la couche de matière électrochrome et une deuxième électrode transparente disposée sur la face externe de la couche d'électrolyte ou de la couche de matière constituant une réserve de cations $Na^+$ quand cette dernière est présente, des moyens étant en outre prévus pour relier ces électrodes à une source de courant électrique.

De préférence, les matières constituant les première et deuxième électrodes sont choisies parmi l'oxyde de zinc dopé en aluminium (ZnO:Al), l'oxyde d'étain dopé en fluor ($SnO_2$:F) et l'oxyde d'indium et d'étain (ITO).

La différence de potentiel à mettre en oeuvre devra être au moins égale à celle permettant la migration des cations $Na^+$ depuis l'électrolyte et la réserve de cations $Na^+$ et leur insertion dans le composé électrochrome.

Plus cette différence de potentiel sera élevée, et plus cette migration, et donc le changement du pouvoir d'absorption de la lumière, seront rapides.

Avantageusement, la cellule selon l'invention comprend en outre un support pour ledit empilement des couches et lesdits moyens pour établir une différence de potentiel.

Selon une première variante, ce support est transparent, est par exemple constitué par du verre ou un polymère transparent tel qu'un polycarbonate, un polystyrène ou un polyéthylène téréphtalate, et peut être pourvu sur sa face externe d'un revêtement réfléchissant (par exemple un métal à surface réfléchissante).

Selon une seconde variante, ledit support est opaque, est par exemple constituée par un polymère tel qu'un polybutadiène, et peut être pourvu d'un revêtement réfléchissant (par exemple métal à surface réfléchissante) disposé sur la face opposée à la face externe dudit support ; on notera que dans le cas où le revêtement réfléchissant est réalisé en un matériau conducteur de l'électricité (métal),ce revêtement fait partie des moyens pour établir une différence de potentiel ou constitue la première électrode.

On ajoutera que dans l'une ou l'autre des deux variantes susvisées, le revêtement réfléchissant, quand il est constitué par un matériau conducteur de l'électricité, peut faire partie d'un circuit chauffant dont la fonction est l'élimination du givre ou de la buée éventuellement déposée sur la cellule.

Les épaisseurs des différents éléments de la cellule sont de préférence comme suit :

- couche de matière électrochrome : 200-600 nm
- couche d'électrolyte : 200-1200 nm
- couche de matière constituant la réserve de cations $Na^+$ : 200-800 nm
- première électrode : 100-500 nm
- deuxième électrode : 100-500 nm
- support : 1-3 mm
- revêtement réfléchissant : 700-1200 nm, et les moyens pour établir une différence de potentiel sont de préférence choisis pour établir une différence de potentiel de 2-4 volts.

La cellule électrochrome qui vient d'être décrite trouve diverses applications.

Ainsi, quand le support est en verre, la cellule peut faire partie d'une vitre.

La présente invention s'étend donc à une vitre, notamment pour véhicule, cette vitre constituant le support transparent en verre de la cellule selon la première variante définie ci-dessus et sans revêtement réfléchissant.

On comprendra que la mise en oeuvre de ladite cellule permet un réglage rapide du niveau thermique et lumineux souhaité à l'intérieur d'un véhicule.

La cellule peut également faire partie d'un rétroviseur.

Par conséquent, la présente invention s'étend en outre à un rétroviseur pour véhicule, comprenant un ensemble réfléchissant la lumière constitué par la cellule électrochrome de la première variante (avec revêtement réfléchissant) ou la seconde variante (avec revêtement réfléchissant) définie ci-dessus.

Lorsque la cellule n'est pas en fonctionnement, c'est-à-dire qu'aucune différence de potentiel n'est établie, le rétroviseur est dans un état très réfléchissant pour une utilisation de jour.

Lorsqu'une différence de potentiel suffisante est établie, il passe à un état moins réfléchissant pour une utilisation de nuit afin de limiter ou de supprimer l'éblouissement d'un conducteur par les phares des véhicules qui le suivent.

La présente invention s'étend par ailleurs à un procédé de fabrication de la cellule électrochrome susvisée.

Ce procédé est caractérisé en ce qu'il comprend le dépôt physique en phase vapeur de la couche d'électrolyte par pulvérisation cathodique, sur au moins un substrat constitué par une partie appropriée préalablement formée de la cellule et dans une atmosphère à pression réduite constituée d'un gaz vecteur neutre et d'oxygène, d'une première cible en un alliage Si-Zr et d'une deuxième cible en $Na_3PO_4$, pour former le composé de formule (1) définie ci-dessus.

On comprendra que, compte tenu de la structure de la cellule électrochrome selon l'invention, le dépôt du composé (1) doit être effectué sur la couche de matière électrochrome ; de ce fait, la couche extérieure du substrat susmentionné pourra être constituée par ladite matière électrochrome, par l'une des électrodes ou par la réserve de cations $Na^+$.

On notera que l'alliage Si-Zr comprend de préférence 40 à 60% en moles de Si, que le pourcentage volumique d'oxygène est de préférence inférieur ou égal au pourcentage volumique du gaz vecteur (par exemple, 5 à 10 parties en volume d'oxygène pour 20 parties en volume de gaz vecteur) et que le gaz vecteur neutre est de préférence de l'argon.

La pulvérisation cathodique susmentionnée peut comprendre la pulvérisation cathodique simultanée des deux cibles.

En variante, la pulvérisation cathodique comprend une opération de pulvérisation cathodique de l'une des cibles, suivie d'une opération de pulvérisation cathodique de l'autre cible, ces opérations étant répétées dans le même ordre.

Lors de la pulvérisation cathodique, la décharge électrique provoque l'ionisation du gaz vecteur avec formation d'atomes de gaz ionisés (par exemple $Ar^+$) qui viennent percuter la cible (cathode). Ceci conduit à l'éjection d'atomes superficiels de la cible.

Dans le cas de la cible Si-Zr, les atomes éjectés de la cible sont transférés sur le substrat à la surface duquel ils réagissent avec l'oxygène présent dans le gaz plasmagène pour former les oxydes $SiO_2$ et $ZrO_2$.

Il en est de même pour la cible de $Na_3PO_4$ dont les atomes éjectés sont directement transférés sur le substrat sans réaction avec l'oxygène présent.

La pulvérisation cathodique devra être réalisée dans des conditions permettant le transfert sur le substrat d'une succession de monocouches chacune sensiblement constituée de deux molécules de $ZrO_2$ et deux molécules de $SiO_2$ pour une molécule de $Na_3PO_4$, résultat auquel l'homme de métier pourra aboutir en choisissant de manière appropriée les différents paramètres disponibles.

On notera ici que la mise en oeuvre d'une cible unique de composé de formule (1) a conduit à un échec, aucun dépôt n'ayant pu être effectué sur le substrat en raison d'un échauffement rédhibitoire de la cible.

De la même manière, l'utilisation d'une cible réalisée par frittage d'un mélange d'une partie de poudre de $Na_3PO_4$, de deux parties de poudre de $ZrO_2$ et deux parties de poudre de $SiO_2$ n'a pas permis le dépôt du composé de formule (1).

En fait, seule a été couronnée de succès, l'utilisation des deux cibles susmentionnées (alliage Si-Zr et $Na_3PO_4$).

Selon un mode de réalisation, le procédé comprend un déplacement relatif entre les cibles et chaque substrat entre une première position dans laquelle il y a essentiellement réception sur un substrat de la vapeur émise par la pulvérisation cathodique de l'une des cibles et une seconde position dans laquelle il y a essentiellement réception sur le même substrat de la vapeur émise par la pulvérisation cathodique de l'autre cible.

Le déplacement est de préférence effectué selon une trajectoire fermée, notamment selon un cercle d'axe (O).

Dans le cas de la mise en oeuvre de plusieurs substrats, le déplacement relatif entre les cibles et les substrats peut être effectué selon des cercles concentriques d'axe (O), les cibles (ou substrats) étant répartis sur ces cercles concentriques.

Selon une variante, le plan médian, parallèle à l'axe (O), d'une cible est sensiblement dans le prolongement du plan médian, parallèle à l'axe (O), du substrat, quand ladite cible et ledit substrat sont dans ladite première position.

Selon une autre variante, les surfaces en regard des cibles et du ou des substrats sont sensiblement planes et parallèles entre elles, et la distance (D1, D2) la plus courte entre les plans contenant respectivement lesdites surfaces est supérieure à D/2 et inférieure à 2D, D étant la distance entre ledit axe (O) et le plan médian, parallèle à cet axe, de la cible considérée.

Par ailleurs, la vitesse du déplacement entre chaque cible et le substrat devra être choisie pour réaliser, comme indiqué précédemment, le dépôt d'une succession de monocouches chacune constituée sensiblement de deux molécules de $ZrO_2$ et deux molécules de $SiO_2$ pour une molécule de $Na_3PO_4$

A cet effet, dans le cas où les cibles présentent chacune une section circulaire prise selon un plan perpendiculaire à l'axe (O), cette vitesse de déplacement relatif devra de préférence répondre à la relation suivante :

$$\frac{V \ D'}{2 \ \pi \ D \ w} \leq 1nm$$

dans laquelle :

V : vitesse de dépôt sur le substrat (en nm/s)
D' : diamètre de la cible (en cm)
D : distance entre l'axe O et le plan médian, parallèle à cet axe, de la cible (en cm)
w : vitesse du déplacement relatif (en tours/s).

Par ailleurs, selon un mode de réalisation possible de l'invention, la pulvérisation cathodique de la cible en alliage Si-Zr est effectuée avec un courant électrique continu pulsé d'une fréquence supérieure à 10 kHz et une densité de courant de 20-60 $mA/cm^2$ et la pulvérisation cathodique de la cible en $Na_3PO_4$ est effectuée avec un courant électrique continu pulsé d'une fréquence supérieure à 200 kHz et une densité de courant de 20-60 $mA/cm^2$, la tension appliquée étant, dans le deux cas, de 175-450V.

Enfin, le procédé de réalisation de la cellule électrochrome peut en outre comprendre le dépôt physique en phase vapeur de chacune des autres couches, des électrodes et du revêtement réfléchissant éventuel de la cellule électrochrome, à l'exception du support.

Ce qui précède montre que la cellule électrochrome selon la présente invention peut être réalisée par mise en oeuvre d'un seul type de processus, celui d'un dépôt physique en phase vapeur et ceci, grâce au choix particulier de l'électrolyte.

Par rapport aux procédés de la technique antérieure, il est possible selon l'invention d'obtenir la couche d'électrolyte avec une bonne précision et reproductibilité de l'épaisseur et des propriétés de conduction ionique et d'éviter les difficultés rencontrées avec les procédés antérieurs.

Le procédé selon l'invention permet en outre l'utilisation de différents types de support (verre ou polymère opaque ou transparent) et notamment des supports en polymère plus léger que le verre, évitant les problèmes de vibration dues à un excès de poids.

L'utilisation de support en polymère permet de réaliser des formes plus complexes que le verre, à quoi s'ajoute le fait que les cellules dont le support est en polymère sont évidemment beaucoup moins fragiles que les supports en verre.

Plusieurs formes d'exécution de l'invention sont décrites ci-après à titre d'exemples illustratifs, en référence aux dessins schématiques annexés dans lesquels :

- la figure 1 est une coupe transversale d'une cellule électrochrome à support transparent et réserve de cations Na+,
- la figure 2 est une coupe transversale d'une cellule électrochrome à support transparent et dépourvue de réserve de cations Na+,
- la figure 3 est une coupe transversale d'une cellule électrochrome à support opaque et réserve de cations Na+,
- la figure 4 est une coupe transversale d'une cellule électrochrome à support opaque et dépourvue de réserve de cations Na+,
- la figure 5 est une représentation schématique d'une installation de pulvérisation cathodique à deux cibles et à porte-substrats rotatifs, et
- la figure 6 est une vue en détail de l'une des cibles et de son support.

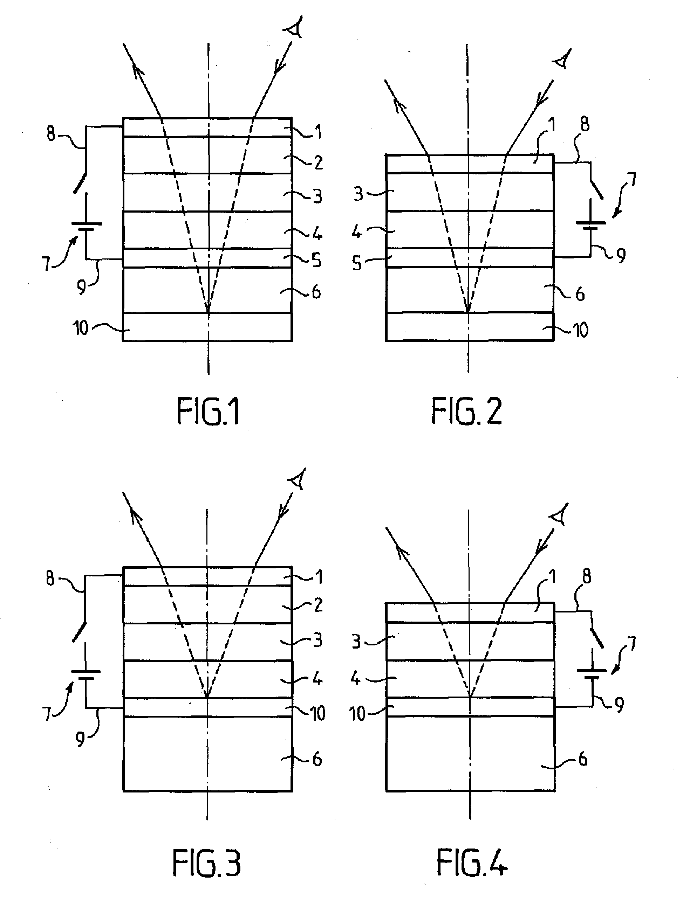

De manière connue en soi, la cellule objet de la figure 1 comprend un empilement constitué, dans cet ordre, d'une électrode 1, d'une couche 2 de réserve de cations Na+, d'une couche 3 d'électrolyte, d'une couche 4 de matière électrochrome, d'une électrode 5 et d'un support 6.

Cet ensemble est complété par une batterie 7 dont l'une 8 des bornes 8, 9 est reliée à l'électrode 1 et l'autre 9 est reliée à l'électrode 5.

Selon la présente invention :

- l'électrolyte formant la couche 3 est en NASICON (forme cristallisée) ou en NASIGLAS (forme amorphe),
- la matière électrochrome formant la couche 4 est de préférence en $WO_3$,
- le réserve de cations $Na^+$ formant la couche 2 est de préférence en $TiO_2$ poreux ou non poreux et dopé avec quelques % de Na, ou en alumine β,
- les électrodes 1 et 5 sont en ZnO:Al, $SnO_2$:F ou ITO, et
- le support 6 est en polymère transparent, notamment en ABS, polycarbonate ou polysulfone.

La cellule ainsi formée comprend en outre un revêtement réfléchissant 10 disposé sur la face externe du support 6 ; ce revêtement est de préférence constitué par un métal (par exemple, alliage aluminium-titane, chrome ou aluminium) à surface réfléchissante.

En l'absence de différence de potentiel entre les électrodes 1 et 5, c'est-à-dire lorsque la batterie n'est pas connectée à ces électrodes, $WO_3$ est incolore et son pouvoir d'absorption de la lumière est minimum, la cellule étant de ce fait très réfléchissante.

Lorsque l'électrode 1 est reliée à la borne positive de la batterie et l'électrode 5 est reliée à la borne négative de la batterie, les cations $Na^+$ de l'électrolyte migrent vers la matière électrochrome $WO_3$ et viennent s'insérer dans cette dernière qui passe de l'état incolore à l'état coloré bleu ; il en résulte une augmentation du pouvoir d'absorption de la matière électrochrome, la cellule étant de ce fait moins réfléchissante.

En inversant la commutation de la batterie, la matière électrochrome retrouve son état incolore initial.

On notera que pour leur part, les cations $Na^+$ de la réserve formant la couche 2 migrent vers l'électrolyte pour venir occuper les sites laissés libres par les cations $Na^+$ ayant migré vers la matière électrochrome, les cations $Na^+$ venant occuper ces sites pouvant éventuellement migrer à leur tour vers la matière électrochrome.

La cellule de la figure 2 est en tous points identiques à celle de la figure 1, si ce n'est qu'elle ne comporte pas de couche 2 de réserve de cations $Na^+$ ; son fonctionnement est le même que celui de la cellule de la figure 1.

La cellule de la figure 3 est identique à celle de la figure 1, si ce n'est que le support 6 est en un polymère opaque (par exemple, en polycarbonate (PC), polysulfone (PSu), polyétherimide (PEI) ou polycarbonate + ABS), que l'électrode 5 a été supprimée, que les positions relatives du support 6 et du revêtement réfléchissant 10 sont inversées par rapport à celles qu'occupent ce support et ce revêtement dans la cellule de la figure 1 et que ledit revêtement 10 joue le rôle de l'électrode 5, ce revêtement 10 étant de ce fait connecté à la batterie 7.

Quant à la cellule de la figure 4, elle est identique à celle de la figure 3, si ce n'est qu'elle ne comporte pas de couche de réserve de cations $Na^+$.

Le fonctionnement des cellules objet des figures 3 et 4 est semblable à celui de la cellule de la figure 1.

On ajoutera que dans les cellules objet des figures 1 et 2, la séquence couche 2 de réserve de cations $Na^+$ - couche 3 d'électrolyte - couche 4 de matière électrochrome peut être modifiée en séquence couche 4 de matière électrochrome - couche 3 d'électrolyte - couche 2 de réserve de cations $Na^+$, auquel cas les polarités des électrodes 1 et 5 devront être inversées pour obtenir le même fonctionnement de la cellule résultant de cette modification de séquence.

Ceci est également valable pour les cellules objet des figures 3 et 4.

Lorsque dans les cellules objet des figures 1 et 2, le revêtement réfléchissant 10 est omis et le support 6 est en verre, celles-ci peuvent être utilisées en tant que vitres, par exemple vitres de véhicules.

Par ailleurs, les cellules objet des figures 1 à 4 peuvent être utilisées en tant qu'ensembles réfléchissants (ou miroirs) pour rétroviseurs.

Exemple 1 : cellule électrochrome conforme à celle objet de la figure 1 et présentant les caractéristiques suivantes :

- électrode 1 : en ZnO:Al et d'une épaisseur de 300 nm
- couche 2 de réserve de cations $Na^+$ : $Na_xTiO_2$ où x = 0,25
- couche 3 de NASICON : épaisseur de 800 nm
- couche 4 en $WO_3$ : épaisseur de 400 nm
- électrode 5 : en ZnO:Al et d'une épaisseur de 300 nm
- support 6 : en polymère ABS, polycarbonate ou polysulfone transparent et d'une épaisseur de 2-3 mm
- revêtement réfléchissant 10 : en alliage aluminium-titane et d'une épaisseur de 1 μm
- différence de potentiel appliquée entre les électrodes 1 et 5 pour provoquer le changement de couleur de la couche 4 de $WO_3$ (incolore → bleue) : 3 volts
- augmentation du pouvoir d'absorption de la couche 4, résultant de l'application de la différence de potentiel ci-dessus : 35 %
- temps nécessaire pour obtenir l'augmentation du pouvoir d'absorption susvisé : 20 secondes
- temps nécessaire pour retrouver le pouvoir d'absorption initial de la couche 4, après inversion du potentiel : 10 secondes.

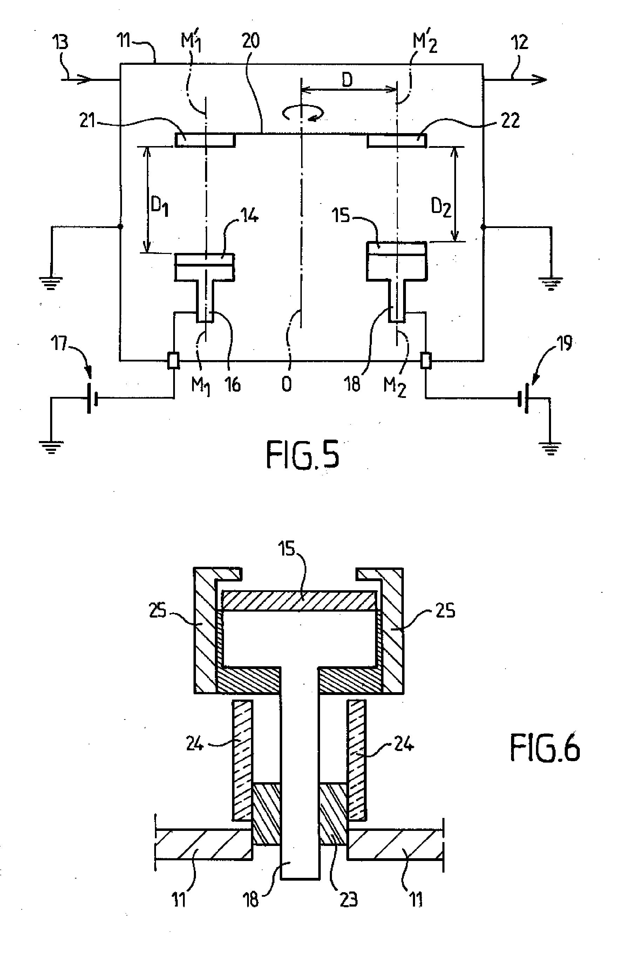

L'installation de pulvérisation cathodique objet de la figure 5 comprend une chambre 11 dans laquelle débouche un conduit 12 reliée à un source de vide (non représentée).

La chambre 11 est en outre pourvue d'une arrivée 13 d'un mélange gazeux plasmagène constitué d'argon et d'oxygène.

A l'intérieur et en partie basse de la chambre 11, sont disposées une première cible 14 et une deuxième cible 15.

La cible 14 est supportée par un élément conducteur de l'électricité 16 (par exemple en acier inoxydable ou cuivre) raccordé électriquement à la cathode d'un générateur électrique 17 de courant continu pulsé dont l'autre borne est à la masse.

De même, la cible 15 est supportée par un élément conducteur de l'électricité 18 (en acier inoxydable ou cuivre par exemple) raccordé électriquement à la cathode d'un autre générateur électrique 19 de courant continu pulsé, dont l'autre borne est à la masse.

La chambre 11 est également reliée à la masse.

En outre, à l'intérieur et en partie haute de la chambre 11 est disposé horizontalement un porte-substrats 20 de forme circulaire et pourvu de moyens (non représentés) pour l'amener en rotation dans un plan horizontal et autour d'un axe vertical (O), avec une vitesse réglable.

Sous le porte-substrats 20 et au voisinage de la périphérie de celui-ci, sont fixés des substrats (ou supports) 21, 22 sur lesquels doivent être transférées, par pulvérisation cathodique, respectivement les matières des cibles 14, 15.

Par ailleurs, les surfaces en regard des substrats 21, 22 et des cibles 14, 15 sont sensiblement planes et horizontales.

On ajoutera que les cibles 14, 15 ont la forme d'un disque et que chaque substrat 21, 22 peut être constitué par une vitre ou par le support d'un rétroviseur, destiné à recevoir un ensemble réfléchissant la lumière.

Les positions relatives des substrats 21, 22 et des cibles 14, 15 sont choisies de telle manière que lors de la rotation du porte-substrats 20, l'un 21 des substrats passe successivement au-dessus de la première cible 14 puis de la deuxième cible 15, alors que pendant le même temps l'autre substrat 22 passe successivement au-dessus de la deuxième cible puis de la première cible.

A cet effet, dans une première position, le plan médian M'$_1$ parallèle à l'axe O du substrat 21, est sensiblement dans le prolongement du plan médian M$_1$ parallèle à l'axe O de la cible 14, et le plan médian M'$_2$ parallèle à l'axe O du substrat 22 est sensiblement dans le prolongement du plan médian M$_2$ parallèle à l'axe O de la cible 15 ; dans une seconde position, le plan médian M'$_1$ susvisé du substrat 21 est sensiblement dans le prolongement du plan médian M$_2$ susvisé de la cible 15, et le plan médian M'$_2$ susvisé du substrat 22 est sensiblement dans le prolongement du plan médian M$_1$ susvisé de la cible 14.

Il est à noter que la forme du porte-substrats, le nombre de substrats et la position de ces derniers sur le porte-substrats ne sont en aucune manière limités à ceux représentés sur la figure 5.

En fait, les substrats peuvent être en nombre quelconque et occuper n'importe quelle position sur et à l'intérieur du cercle d'axe (O) délimité par le bord périphérique du porte-substrats 20.

Ce dernier peut présenter n'importe quelle forme sur laquelle les substrats pourraient être répartis selon une disposition quelconque.

Ainsi, le porte-substrats pourrait par exemple être constitué d'une plaque circulaire d'axe (O) et les substrats répartis à volonté sur cette plaque, par exemple sur des cercles concentriques d'axe (O).

On signalera ici qu'un substrat positionné sur l'axe (O) reçoit un flux constant de matière.

Dans le cas des positions extrêmes des substrats montrées sur la figure 5, le flux de matière parvenant à un substrat donné depuis une cible donnée varie de manière régulière entre une valeur maximale quand la distance entre la cible et le substrat est minimum et une valeur minimale quand ladite distance est maximum.

Par ailleurs, une variante au déplacement circulaire des substrats 21, 22 consisterait à prévoir des cibles de forme linéaire et allongée et de déplacer lesdits substrats au-dessus de ces cibles, suivant un mouvement linéaire d'aller-retour.

L'installation ci-dessus définie est utilisée selon l'invention pour réaliser un dépôt d'un composé de la série des NASICON et à cet effet, la première cible est en alliage Si-Zr (à 40-60% de Si) et la deuxième cible est en $Na_3PO_4$.

On précisera que les substrats 21, 22 sont de préférence constitués chacun par la partie de cellule électrochrome, destinée à recevoir la couche 3 d'électrolyte.

Cette partie de la cellule peut comprendre, dans cet ordre :

- le support transparent 6, l'électrode 5 et la couche 4 de matériel électrochrome, ou
- le revêtement réfléchissant 10, le support transparent 6, l'électrode 5 et la couche 4 de matière électrochrome, ou
- le support opaque 6, le revêtement réfléchissant 10 et la couche 4 de matière électrochrome.

Cette installation fonctionne de la manière suivante.

On établit le vide à l'intérieur de la chambre 11, par exemple au moyen d'une pompe turbo-moléculaire permettant d'atteindre un vide primaire de l'ordre de $10^{-4}$ Pa.

On introduit ensuite dans la chambre 11 un gaz plasmagène par l'arrivée 13, pour obtenir et maintenir dans ladite chambre une pression de l'ordre 0,4 Pa.

Le porte-substrats 20 est alors amené en rotation.

Puis on relie l'élément conducteur 16 à la cathode du générateur électrique 17 et l'élément conducteur 18 à la cathode du générateur électrique 19.

Les tensions aux bornes respectivement des générateurs 17 et 19 sont sélectionnées pour obtenir une décharge électrique entre la paroi de la chambre 11 et les cibles 14, 15 respectives.

Ces tensions sont de 175-450 Volts.

Pour la cible en Si-Zr, cette tension est obtenue avec un générateur 17 de courant continu pulsé d'une fréquence supérieure à 10 kHz et pour la cible $Na_3PO_4$, cette tension est obtenue avec un générateur 19 de courant continu pulsé d'une fréquence de 200-350 kHz.

Par ailleurs, la densité du courant au niveau des cibles est de préférence de l'ordre 20-60 mA/cm$^2$.

Les espèces $Ar^+$ générées par les décharges viennent percuter les cibles qui sont de ce fait localement vaporisées, la vapeur produite venant se condenser sur les substrats.

Dans le cas de la cible 14 en Si-Zr, les atomes de Si et de Zr sont en outre transformés en oxydes correspondants $SiO_2$ et $ZrO_2$, lors de leur condensation sur les substrats.

Le dépôt sur les substrats doit être réalisé pour former sur ceux-ci une couche de NASICON, ce qui implique le dépôt de deux molécules de $SiO_2$ et de deux molécules de $ZrO_2$ pour une molécule de $Na_3PO_4$.

Pour cette raison, la vitesse de rotation du porte-substrats 20 doit être choisie de manière appropriée, c'est-à-dire pour former non pas des couches successives de $SiO_2$, $ZrO_2$ et $Na_3PO_4$, mais un NASICON.

A cet effet, les relations suivantes doivent être respectées dans toute la mesure du possible :

$$D/2 < D1 \text{ ou } D2 < 2D$$

$$\frac{VD'}{2\pi \, D \, w} \leq 1 \text{ nm}$$

dans lesquelles D est la distance entre l'axe O et le plan médian $M_1$, $M_2$, $D_1$ est la distance entre les surfaces en regard du substrat 21 et de la cible 14, $D_2$ est la distance entre les surfaces en regard du substrat 22 et de la cible 15 et les différents autres paramètres ont les mêmes significations que celles données dans la description ci-dessus.

On précisera encore que la cible 14 en Si-Zr est obtenue en frittant un mélange de poudre de Si et de poudre de Zr, à une température de 1000-1300°C et sous une pression supérieure à 100 kg/cm$^2$ ($10^7$Pa).

Quant à la cible 15 de $Na_3PO_4$, elle est obtenue par pressage à plus de $10^8$ Pa à froid d'une poudre de $Na_3PO_4$ anhydre et d'une granulométrie inférieure à 200 $\mu$m.

Enfin, la figure 6 est une vue plus détaillée de l'ensemble cible 15/élément conducteur 18, suivant un autre mode de réalisation que celui de la figure 5.

Ainsi, l'élément 18 est prolongé à sa base pour s'étendre jusqu'à l'extérieur de la chambre 11, en traversant la paroi inférieure de cette dernière avec interposition d'un élément isolant 23 (en téflon ou bakélite par exemple) entre l'élément 18 et ladite paroi.

Afin de protéger le dépôt de NASICON formé sur les substrats 21, 22 de la contamination due à des pulvérisations parasites de l'isolant 23 et de la matière conductrice constituant l'élément 18, produites en raison de la fréquence élevée du courant utilisé pour la cible 15 en $Na_3PO_4$, ledit isolant 23 et ledit élément 18 sont entourés d'un écran 24 conformé pour limiter, voire supprimer l'accès aux substrats 21, 22 de la vapeur de la matière conductrice de l'élément 18 et de la vapeur de la matière de l'isolant 23.

Un écran 25 est en outre prévu autour du bord périphérique circulaire de chaque cible pour faire barrière à la matière libérée à partir de ce bord lors de la pulvérisation cathodique.

Les écrans 24, 25 peuvent être en verre, fibres de verre ou en métal (par exemple fer) revêtu de verre ou de fibres de verre.

Exemple 2 : Conditions de pulvérisation cathodique de la cible en Si-Zr (45 % de Si)

- distance D : 6 cm
- distance D1 : 9,5 cm
- diamètre de la cible : 5 cm
- w : 2 tours/s
- pression du gaz plasmagène (Ar + $O_2$) : 0,4 Pa
- pression partielle de Ar dans le gaz plasmagène : 0,3 Pa
- densité de courant: 36 mA/cm$^2$
- tension du courant pulsé : 380 volts
- fréquence du courant pulsé : 20 kHz

Exemple 3 : Conditions de pulvérisation cathodique de la cible en $Na_3PO_4$ :

- distance D : 6 cm
- distance D2 : 4,5 cm
- diamètre de la cible : 5 cm
- w : 2 tours/s
- pression du gaz plasmogène (Ar+$O_2$) : 0,4 Pa
- pression partielle de Ar dans le gaz plasmagène 0,3 Pa
- densité de courant : 36 mA/cm$^2$
- tension du courant pulsé : 300 volts
- fréquence du courant pulsé. 275 kHz.

Toutes les autres couches de la cellule selon l'invention, c'est-à-dire la couche 2 de réserve de cations $Na^+$, la couche 4 de matière électrochrome, les électrodes 1, 5 et le revêtement réfléchissant 10, à l'exclusion du support 6, peuvent selon l'invention être réalisées chacune par la même technique de pulvérisation cathodique que celle utilisée pour réaliser la couche 3 d'électrolyte.

L'homme du métier trouvera dans les documents de la technique antérieure toutes informations utiles sur les cibles et les conditions opératoires à mettre en oeuvre pour la réalisation de ces autres couches, électrodes et revêtement, par pulvérisation cathodique.

Ainsi, on donnera les informations suivantes à titre d'exemples :

électrode en ZnO:Al

- cible en Zn et cible en Al co-pulvérisées simultanément
- gaz plasmagène : argon+$O_2$, avec une proportion de $O_2$ de 2 à 30%
- pression du gaz plasmagène : 0,3-0,8 Pa
- tension appliquée à la cible en Al : courant pulsé (20-100 kHz) de 100-200 V
- tension appliquée à la cible en Zn : courant continu de 300-450 V

couche de $WO_3$

- cible en W
- gaz plasmagène : argon+$O_2$, avec une proportion de $O_2$ de 15 à 40%
- pression du gaz plasmagène : 2-4 Pa
- tension appliquée à la cible en W : courant pulsé (20-50 kHz) de 450-600 V

couche de $Na_xTiO_2$ (réserve de $Na^+$)

- cible en Ti et cible en $Na_3PO_4$ co-pulvérisées simultanément
- gaz plasmagène : argon+$O_2$, avec une proportion de $O_2$ de 5 à 30%
- pression du gaz plasmagène : 0,3-0,8 Pa (dans le cas de la réalisation d'un produit dense et 2-4 Pa dans le cas de la réalisation d'un produit poreux)
- tension appliquée à la cible en $Na_3PO_4$ : courant pulsé (200-350 kHz) de 175-350 V tension appliquée à la cible en Ti : courant continu de 350-500 V

**Revendications**

1. Cellule électrochrome comportant un empilement de couches comprenant une couche (4) de matière électrochrome inorganique et transparente, une couche (3) d'un électrolyte inorganique et transparent appliquée sur ladite couche (4) de matière électrochrome et une couche (2) de matière transparente constituant une réserve de cations $Na^+$, disposée sur la face externe de la couche (3) d'électrolyte et dotée de propriétés de conduction ionique, des moyens étant prévus pour établir une différence de potentiel entre les couches (3) et (4) et la matière électrochrome et l'électrolyte étant choisis pour que sous l'effet de cette différence de potentiel des cations $Na^+$ migrent, de manière réversible, depuis l'électrolyte vers la matière électrochrome pour venir s'insérer dans cette dernière en provoquant une modification de son pouvoir d'absorption de la lumière, dans laquelle l'électrolyte comprend au moins un composé de formule générale

$$Na_{1+x}\, Zr_2\, Si_x\, P_{3-x}\, O_{12} \qquad (1)$$

dans laquelle x est choisi pour répondre aux conditions suivantes : $1{,}6 \leq x \leq 2{,}4$, **caractérisée en ce que** la matière constituant une réserve de cations $Na^+$ comprend de l'oxyde de titane ($TiO_2$) poreux ou non poreux et dopé en Na ou une alumine $\beta$.

2. Cellule selon la revendication 1, **caractérisée en ce que** lesdits moyens pour établir une différence de potentiel comprennent une première électrode transparente (5) disposée sur la face externe de la couche (4) de matière électrochrome et une deuxième électrode transparente (1) disposée sur la face externe de la couche (3) d'électrolyte ou de la couche (2) de matière constituant une réserve de cations $Na^+$ quand cette dernière est présente, des moyens étant en outre prévus pour relier ces électrodes à une source de courant électrique (7).

3. Cellule selon la revendication 2, **caractérisée en ce que** les matières constituant les première et deuxième électrodes sont choisies parmi l'oxyde de zinc dopé en aluminium (ZnO:Al), l'oxyde d'étain dopé en fluor ($SnO_2$:F) et l'oxyde d'indium et d'étain (ITO).

4. Cellule selon la revendication 1, 2 ou 3, **caractérisée en ce que** dans la formule (1) x est sensiblement égal à 2.

5. Cellule selon l'une quelconque des revendications 1 à 4, **caractérisée en ce que** la matière électrochrome est constituée par de l'oxyde de tungstène ($WO_3$) ou de l'oxyde de vanadium ($V_2O_5$).

6. Cellule selon l'une quelconque des revendications précédentes, **caractérisée en ce qu'**elle comprend en outre un support (6) pour ledit empilement et lesdits moyens pour établir une différence de potentiel.

7. Cellule selon la revendication 6 **caractérisée en ce que** le support (6) est transparent.

8. Cellule selon la revendication 7, **caractérisée en ce que** le support (6) est constitué par du verre ou un polymère transparent.

9. Cellule selon la revendication 7 ou 8, **caractérisée en ce que** ledit support (6) est pourvu sur sa face externe d'un revêtement réfléchissant (10).

10. Cellule selon la revendication 6, **caractérisée en ce que** le support (6) est opaque et est pourvu d'un revêtement réfléchissant (10) disposé sur la face opposée à sa face externe.

11. Cellule selon la revendication 10, **caractérisée en ce que** ledit revêtement réfléchissant (10) est un conducteur électrique et fait partie desdits moyens pour établir une différence de potentiel ou constitue ladite première électrode (5).

12. Cellule selon l'une quelconque des revendications 2 à 11, **caractérisée en ce que** les épaisseurs de ses différents éléments sont comme suit :

   - couche de matière électrochrome : 300-500 nm
   - couche d'électrolyte : 300-1200 nm
   - couche de matière constituant la réserve de cations $Na^+$ : 200-600 nm
   - première électrode : 100-300 nm

EP 1 862 849 A1

- deuxième électrode : 100-300 nm
- support : 1-3 mm
- revêtement réfléchissant : 700-1200 nm,

et **en ce que** les moyens pour établir une différence de potentiel sont choisis pour établir une différence de potentiel de 2-4 volts.

**13.** Vitre, notamment pour véhicule, **caractérisée en ce qu'**elle comprend la cellule selon la revendication 8 ou 12, la vitre constituant le support (6) transparent en verre de cette cellule.

**14.** Rétroviseur pour véhicule, comprenant un ensemble réfléchissant la lumière, **caractérisé en ce que** ledit ensemble est constitué par la cellule électrochrome selon l'une quelconque des revendications 9 à 12.

**15.** Procédé de réalisation de la cellule électrochrome selon l'une quelconque des revendications 1 à 12, **caractérisé en ce qu'**il comprend le dépôt physique en phase vapeur de la couche d'électrolyte (3) par pulvérisation cathodique, sur au moins un substrat constitué par une partie préalablement formée de la cellule et dans une atmosphère à pression réduite constituée d'un gaz vecteur neutre et d'oxygène, d'une première cible (14) en un alliage Si-Zr et d'une deuxième cible (15) en $Na_3PO_4$, pour former le composé de formule (1) définie à la revendication 1 ou 4.

**16.** Procédé selon la revendications 15, **caractérisé en ce que** la pulvérisation cathodique de la cible en alliage Si-Zr est effectuée avec un courant électrique continu pulsé d'une fréquence supérieure à 10 kHz et une densité de courant de 20-60 $mA/cm^2$ et la pulvérisation cathodique de la cible en $Na_3PO_4$ est effectuée avec un courant électrique continu pulsé d'une fréquence supérieure à 200 kHz et une densité de courant de 20-60 $mA/cm^2$, la tension appliquée étant, dans le deux cas, de 175-450V.

**17.** Procédé selon la revendication 15 ou 16, **caractérisé en ce qu'**il comprend un déplacement relatif entre les cibles et chaque substrat entre une première position dans laquelle il y a essentiellement réception sur un substrat de la vapeur émise par la pulvérisation cathodique de l'une des cibles et une seconde position dans laquelle il y a essentiellement réception sur ce même substrat de la vapeur émise par la pulvérisation cathodique de l'autre cible.

**18.** Procédé selon la revendication 17, **caractérisé en ce que** le déplacement relatif est effectué selon un cercle d'axe (O).

**19.** Procédé selon la revendication 18 mettant en oeuvre plusieurs substrats, **caractérisé en ce que** le déplacement relatif entre les cibles et les substrats est effectué selon des cercles concentriques d'axe (O), les cibles ou les substrats étant répartis sur ces cercles concentriques.

**20.** Procédé selon la revendication 18, **caractérisé en ce que** le plan médian, parallèle à l'axe (O), d'une cible est sensiblement dans le prolongement du plan médian, parallèle à l'axe (O), du substrat, quand ladite cible et ledit substrat sont dans ladite première position.

**21.** Procédé selon la revendication 18, 19 ou 20, **caractérisé en ce que** les surfaces en regard des cibles et du ou des substrats sont sensiblement planes et parallèles entre elles et **en ce que** la distance ($D_1$, $D_2$) la plus courte entre les plans contenant respectivement lesdites surfaces est supérieure à D/2 et inférieure à 2D, D étant la distance entre ledit axe (O) et le plan médian, parallèle à cet axe, de la cible considérée.

**22.** Procédé selon l'une quelconque des revendications 18 à 21, dans lequel les cibles présentent chacune une section circulaire prise selon un plan sensiblement perpendiculaire audit axe (O), **caractérisé en ce que** la vitesse du déplacement relatif est choisie pour répondre à la relation suivante :

$$\frac{V\ D'}{2\ \pi\ D\ w} \le 1nm$$

dans laquelle :

V : vitesse de dépôt sur le substrat (en nm/s)
D' : diamètre de la cible (en cm)
D : distance entre l'axe (O) et le plan médian, parallèle à cet axe, de la cible (en cm)
w : vitesse du déplacement relatif (en tours/s).

23. Procédé selon l'une quelconque des revendications 15 à 17, **caractérisé en ce que** l'alliage Si-Zr comprend 40 à 60% en moles de Si.

24. Procédé selon l'une quelconque des revendications 15 à 17, **caractérisé en ce que** le pourcentage volumique d'oxygène est inférieur ou égal au pourcentage volumique du gaz vecteur.

25. Procédé selon l'une quelconque des revendications 15 à 17, **caractérisé en ce que** la pulvérisation cathodique comprend la pulvérisation cathodique simultanée des deux cibles.

26. Procédé selon l'une quelconque des revendications 15 à 17, **caractérisé en ce que** la pulvérisation cathodique comprend une opération de pulvérisation cathodique de l'une des cibles, suivie d'une opération de pulvérisation cathodique de l'autre cible, ces opérations étant répétées dans le même ordre.

27. Procédé selon l'une quelconque des revendications 15 à 26, **caractérisé en ce qu'**il comprend en outre le dépôt physique en phase vapeur par pulvérisation cathodique, de chacune des autres couches, des électrodes et du revêtement réfléchissant éventuel de la cellule électrochrome, à l'exception du support.

FIG.1

FIG.2

FIG.3

FIG.4

FIG.5

FIG.6

**EP 1 862 849 A1**

Office européen
des brevets

**RAPPORT DE RECHERCHE EUROPEENNE**

Numéro de la demande

EP 07 30 1062

## DOCUMENTS CONSIDERES COMME PERTINENTS

| Catégorie | Citation du document avec indication, en cas de besoin, des parties pertinentes | Revendication concernée | CLASSEMENT DE LA DEMANDE (IPC) |
|---|---|---|---|
| Y | GB 1 591 234 A (TEXAS INSTRUMENTS INC) 17 juin 1981 (1981-06-17) * le document en entier * * revendications 1,2 * ----- | 1-27 | INV. G02F1/15 C23C14/34 |
| Y | US 4 297 005 A (JOHNSON JR DAVID W ET AL) 27 octobre 1981 (1981-10-27) * colonne 2, ligne 19 - ligne 37 * ----- | 1-27 | |
| Y | HORWAT D ET AL: "Sodium superionic conductor sputter-deposited coatings" Ionics Inst. Ionics Germany, vol. 11, no. 1-2, janvier 2005 (2005-01), pages 120-125, XP009076259 ISSN: 0947-7047 * le document en entier * ----- | 15-27 | |
| A | EP 0 087 590 A2 (VARTA BATTERIE [DE]; ROSENTHAL TECHNIK AG [DE]) 7 septembre 1983 (1983-09-07) * page 4, ligne 14 - ligne 27 * * revendication 2 * ----- | 1 | DOMAINES TECHNIQUES RECHERCHES (IPC) G02F C23C |
| A | DE 30 16 524 A1 (MAX PLANCK GESELLSCHAFT [DE]) 5 novembre 1981 (1981-11-05) * revendication 7 * * page 16, ligne 21 - ligne 35 * ----- | 4,5 | |
| A | US 4 049 891 A (HONG HENRY Y-P ET AL) 20 septembre 1977 (1977-09-20) * le document en entier * ----- | 1-16 | |
| A | US 4 258 984 A (BENI GERARDO ET AL) 31 mars 1981 (1981-03-31) * colonne 1, ligne 11 - ligne 32 * ----- | 4,5 | |

Le présent rapport a été établi pour toutes les revendications

| Lieu de la recherche | Date d'achèvement de la recherche | Examinateur |
|---|---|---|
| Munich | 3 juillet 2007 | Girardin, François |

CATEGORIE DES DOCUMENTS CITES

X : particulièrement pertinent à lui seul
Y : particulièrement pertinent en combinaison avec un autre document de la même catégorie
A : arrière-plan technologique
O : divulgation non-écrite
P : document intercalaire

T : théorie ou principe à la base de l'invention
E : document de brevet antérieur, mais publié à la date de dépôt ou après cette date
D : cité dans la demande
L : cité pour d'autres raisons

& : membre de la même famille, document correspondant

EPO FORM 1503 03.82 (P04C02)

15

## ANNEXE AU RAPPORT DE RECHERCHE EUROPEENNE
## RELATIF A LA DEMANDE DE BREVET EUROPEEN NO.

EP 07 30 1062

La présente annexe indique les membres de la famille de brevets relatifs aux documents brevets cités dans le rapport de recherche européenne visé ci-dessus.
Lesdits members sont contenus au fichier informatique de l'Office européen des brevets à la date du
Les renseignements fournis sont donnés à titre indicatif et n'engagent pas la responsabilité de l'Office européen des brevets.

03-07-2007

| Document brevet cité au rapport de recherche | | | Date de publication | Membre(s) de la famille de brevet(s) | | | Date de publication |
|---|---|---|---|---|---|---|---|
| GB | 1591234 | A | 17-06-1981 | CH | 620523 | A5 | 28-11-1980 |
| | | | | DE | 2749916 | A1 | 18-05-1978 |
| | | | | JP | 53077886 | A | 10-07-1978 |
| US | 4297005 | A | 27-10-1981 | JP | 56042215 | A | 20-04-1981 |
| EP | 0087590 | A2 | 07-09-1983 | DE | 3207131 | A1 | 08-09-1983 |
| | | | | JP | 58204405 | A | 29-11-1983 |
| | | | | US | 4504120 | A | 12-03-1985 |
| DE | 3016524 | A1 | 05-11-1981 | AUCUN | | | |
| US | 4049891 | A | 20-09-1977 | DE | 2634289 | A1 | 22-12-1977 |
| | | | | JP | 1062699 | C | 31-08-1981 |
| | | | | JP | 52156200 | A | 26-12-1977 |
| | | | | JP | 56005687 | B | 06-02-1981 |
| US | 4258984 | A | 31-03-1981 | CA | 1124379 | A1 | 25-05-1982 |

EPO FORM P0460

Pour tout renseignement concernant cette annexe : voir Journal Officiel de l'Office européen des brevets, No.12/82